# EUROPÄISCHE PATENTANMELDUNG

(11) **EP 4 779 414 A1**
(43) Veröffentlichungstag der Anmeldung: **22.07.2026**
(21) Anmeldenummer: 26150638.0
(22) Anmeldetag: 07.01.2026
(51) Int. Cl.: G04F 5/14, H01S 3/13, H03L 7/16

(54) **VORRICHTUNG UND VERFAHREN ZUM ERZEUGEN EINES FREQUENZSTABILEN RF-SIGNALS**

(30) Priorität: 07.01.2025 DE 102025100229
(71) Anmelder: Deutsches Zentrum für Luft- und Raumfahrt e.V., 53227 Bonn (DE)
(72) Erfinder: Furthner, Johann, 53227 Bonn (DE); Dominguez, Pablo Nahuel, 53227 Bonn (DE); Trainotti, Christian, 53227 Bonn (DE); Blümel, Ludwig, 81241 Pasing (DE); Agazzi, Laura, 82319 Starnberg (DE); Schmidt, Tobias, 53227 Bonn (DE); Zechel, Thomas, 53227 Bonn (DE)
(74) Vertreter: dompatent

(57) **Zusammenfassung**

Die Erfindung betrifft eine Vorrichtung zum Erzeugen eines frequenzstabilen RF-Signals, sowie ein Verfahren zum Erzeugen eines frequenzstabilen RF-Signals, wobei die Vorrichtung zum Erzeugen eines frequenzstabilen RF-Signals aufweist: Mehrere elektromagnetische StrahlungsQuellen, mindestens einen Uhren-Kanal und einen Realisierungs-Kanal, welcher eine elektromagnetische Strahlungs-Quelle aufweist (OFR #1; FR #1) und deren elektromagnetische Welle auf einen gewichteten mittleren Frequenz- und Phasen-Wert stabilisiert und so ein gewichtetes mittleres frequenzstabiles RF-Signal erzeugt.

## Beschreibung

Die Erfindung betrifft eine Vorrichtung zum Erzeugen eines frequenzstabilen RF-Signals, sowie ein Verfahren zum Erzeugen eines frequenzstabilen RF-Signals.

Aus dem Stand der Technik ist bekannt, dass Vorrichtungen zum Erzeugen eines frequenzstabilen RF-Signals oder Uhrenensembles genutzt werden, um ein stabiles und robustes Zeitsignal zu erzeugen. Das Uhrenensemble, oder auch "Composite Clock" genannt, vereint dazu die Signale verschiedener Uhren(typen) und erzeugt einen gewichteten Mittelwert aus allen Signalen. Stabilere Signale werden dann für entsprechende Integrationszeiten stärker gewichtet. Als Endergebnis erhält man schließlich ein neues Uhrensignal, das die Vorteile hinsichtlich der Performanz der verschiedenen Uhren im Ensemble vereint. Das so erzeugte Ensemble-Uhrensignal ist theoretisch für alle Integrationszeiten robuster und stabiler als jeder einzelne Uhrenbeitrag des Ensembles. In der Praxis kommt es durch die Realisierung des Ensemble-Uhrensignals zu einer geringen Degradation durch den Steuerungszyklus, der benötigt wird, um ein reales Uhrensignal gegen die numerische Lösung des Ensembles zu steuern. Darüber hinaus sind Uhrenensembles in der Lage, die Degradation des Ensemble-Uhrensignals aufgrund individueller Uhrenfehler mittels entsprechender "real-time" Gewichtung zu eliminieren und/oder zu minimieren.

Im Stand der Technik werden Uhrenensembles nur aus klassischen Uhrensignalen (meist 5 MHz, 10 MHz oder 100 MHz) von Mikrowellenfrequenzreferenzen, wie z.B. Cs- oder Rb-Atomuhren, Quarzoszillatoren (OCXO; Oven Controlled Quartz Oscillator) und Wasserstoffmasern, zusammengesetzt und realisiert. Hierbei werden die Uhrensignale gegeneinander in Phase und Frequenz vermessen und die Messergebnisse einem Computeralgorithmus übermittelt. Dieser Algorithmus berechnet dann ein gewichtetes Mittel der Uhrenbeiträge (stabilere Uhrensignale werden stärker gewichtet). Bezüglich der Gewichtung gibt es mehrere verschiedene Lösungsansätze, einer der häufig verwendeten Gewichtungsmechanismen ist die Berechnung des sogenannten "Implicit Ensemble Mean" (IEM) unter Verwendung des "Greenhall"-Algorithmus (Metrologia, vol. 43, no. 4, pp. S311-S321, 2006). Hierbei wird die Schätzung des zukünftigen Uhrenverhaltens über einen Kalman Filter (Transactions of the ASME-Journal of Basic Engineering, vol. 82, no. Series D, pp. 35-45, 1960.) bewerkstelligt. Die IEM wird dann aus diesen Schätzwerten gebildet. Die Lösung des IEM wird schließlich auf ein Uhrensignal des Uhrenensembles aufgeprägt und so die Realisierung erreicht. Meist wird hierfür ein kurzzeitstabiles Signal z.B. eines OCXO-Oszillators aktiv mittels Phasen- und Frequenzverschiebung gesteuert. Andere Algorithmen benutzen ähnliche Gewichtungen der Uhrensignale und benutzen zur Realisierung ebenfalls die Steuerung eines Uhrensignals aus dem Ensemble oder einer externen Frequenzreferenz, die aber gegen zumindest eine Uhr/Frequenzreferenz aus dem Ensemble vermessen werden muss.

Dadurch, dass für die zukünftige Definition der Sekunde höchst wahrscheinlich ein elektronischer Übergang in einem Atom herangezogen wird, dessen Übergangsfrequenz im optischen Bereich liegt, spricht vieles dafür, dass der momentane Sekundenfrequenzstandard, der durch einen Cäsiumübergang im Mikrowellenbereich aus einer Cesium Fountain Atomic Clock definiert wird, durch einen optischen Frequenzstandard ersetzt wird. Als potenzielle Kandidaten für diese Rolle gelten beispielsweise Aluminium, Ytterbium oder Strontium. Aus diesem Grund dürften optische Frequenzreferenzen in der Zukunft eine noch bedeutendere Rolle einnehmen als bisher schon.

Aufgabe der Erfindung ist es, eine Vorrichtung zum Erzeugen eines frequenzstabilen RF-Signals bereitzustellen, die eine höhere Stabilität erreicht, als bisherige Vorrichtungen zum Erzeugen eines frequenzstabilen RF-Signals. Es soll ferner ein entsprechendes Verfahren zum Erzeugen eines frequenzstabilen RF-Signals bereitgestellt werden.

Die Lösung der Aufgabe erfolgt erfindungsgemäß durch die Ansprüche 1 und 14.

Die Vorrichtung zum Erzeugen eines frequenzstabilen RF-Signals weist mehrere elektromagnetische Strahlungs-Quellen auf (OFR #1 - OFR #N; FR #1 - FR #N), insbesondere im optischen und/oder Mikrowellenspektrum, wie Laser und/oder Maser, oder Kernübergänge welche bevorzugt eine kohärente elektromagnetische Welle, bevorzugt einer Wellenlänge zwischen 400nm und 2000nm oder 100nm und 500nm emittieren. Die elektromagnetischen Strahlungs-Quellen könnten als Uhrensignale wie aus dem Stand der Technik bekannt ausgestaltet sein. Eine Vorrichtung, welche aus mehreren elektromagnetischen Strahlungs-Quellen mindestens ein frequenzstabiles RF-Signal erzeugt, nennt man Ensemble.

Die Vorrichtung weist ferner einen Realisierungs-Kanal auf, welcher eine elektromagnetische Strahlungs-Quelle aufweist (OFR #1; FR #1) und dessen elektromagnetische Welle auf einen gewichteten mittleren Frequenz- und Phasen-Wert stabilisiert wird und so ein gewichtetes mittleres frequenzstabiles RF-Signal erzeugt. Der gewichtete mittlere Frequenz- und Phasen-Wert wird durch die Mittelung über mehrere Uhren-Kanäle erzeugt, sodass der Drift und/oder die Frequenzstabilität der elektromagnetischen Strahlungs-Quelle des Realisierungs-Kanals mit einem Frequenz- und Phasen-Offset Generator korrigiert werden kann.

Die Vorrichtung weist ferner mindestens einen Uhren-Kanal, welcher eine zusätzliche elektromagnetische Strahlungs-Quelle (OFR #1 - OFR #N, FR #1 - FR #N) aufweist, die nicht Teil des Realisierungs-Kanals ist, auf.

Die Vorrichtung weist ferner mindestens eine Zähleinheit, welche die Frequenz- und Phasenunterschiede zwischen dem Realisierungs-Kanal und den unterschiedlichen Uhren-Kanälen vermisst, auf. In einer bevorzugten Ausführungsform ist die Zähleinheit ausgebildet, um ein oder mehrere elektrische Signale zu zählen, welche aus einer Schwebung zwischen dem Realisierungs-Kanal und jeweils einem Uhren-Kanal erzeugt werden. Hierbei wird zum Beispiel ein Frequenzkamm (OFC) auf den Realisierungskanal stabilisiert. Im Anschluss wird jeweils ein Signal eines Uhren-Kanals mit dem Frequenzkamm überlagert. Ein kleiner Frequenz- und/oder Phasenunterschied sorgt für ein optisches Schwebungs-Signal, welches von einer Beat Detection Einheit pro Uhren-Kanal in ein elektrisches Signal umgewandelt wird, dessen Wellen von der Zähleinheit gezählt werden können. In einer bevorzugten Ausführungsform hat die Zähleinheit mindestens einen Eingang für jeden Uhren-Kanal.

Eine Beat Detection Einheit (BDU) hat bevorzugt einen optischen Eingang für eine optische Referenz und einen zweiten optischen Eingang für den optischen Frequenzkamm (OFC). Eine BDU kann bevorzugt als Photodiode ausgebildet sein. Eine BDU wird bevorzugt genutzt, um zwei optische Signale zu überlagern und von der Photodiode der BDU gemessen. Das elektrische Signal der Photodiode beinhaltet dann die Schwebungsfrequenz der beiden überlagerten optischen Signale und damit deren Frequenzunterschied. Es ist weiterhin bevorzugt, dass die BDU einen optischen Filter aufweist, um höhere Harmonische oder unerwünschte Signale zu unterdrücken.

Die Vorrichtung weist ferner mindestens eine Frequenz- und Phasenversatz Berechnungseinheit auf, welche basierend auf allen oder einer Untermenge der Frequenz- und/oder Phasenunterschiede des Realisierungs-Kanals und der unterschiedlichen Uhren-Kanäle eine gewichtete mittlere virtuelle Frequenzreferenz berechnet.

In einer bevorzugten Ausführungsform können die Messungen aller oder einer Untermenge der Eingänge der Zähleinheit genutzt werden, um eine gewichtete mittlere virtuelle Frequenzreferenz zu berechnen. Zur Berechnung der gewichteten mittleren virtuellen Frequenzreferenz kann bevorzugt der Greenhall-Algorithmus verwendet werden.

Die Vorrichtung weist ferner mindestens einen Frequenz- und Phasen-Offset Generator auf, welcher, basierend auf der gewichteten mittleren virtuellen Frequenzreferenz der Frequenz und Phasenversatz Berechnungseinheit, die Frequenz und/oder Phase des Realisierungs-Kanals in Richtung der berechneten gewichteten mittleren virtuellen Frequenzreferenz verschiebt. Der Frequenz- und Phasen-Offset Generator kann bevorzugt als akustooptischer Modulator, elektrooptischer Modulator, oder magnetooptischer Modulator ausgebildet sein. Bevorzugt werden diese Phasen-Offset Generatoren mit einer Ansteuerung, bevorzugt mit einem RF-Signalgenerator (DDS) betrieben. Es ist weiterhin bevorzugt, dass ein Phasen-Offset Generator im Mikrowellenbereich zum Einsatz kommt. Besonders bevorzugt ist hier ein elektronischer Offset-Generator im Mikrowellenbereich.

In einer bevorzugten Ausführungsform weist der Realisierungs-Kanal eine elektromagnetische Strahlungs-Quelle im optischen Spektrum, eine Beat Detection Einheit und einen Frequenzkamm auf, wobei der Frequenzkamm mit Hilfe der Beat Detection-Einheit auf die Frequenz und Phase der elektromagnetischen Welle der elektromagnetischen Strahlungs-Quelle im optischen Spektrum des Realisierungskanals stabilisiert wird. In einer optionalen Ausführungsform wird die Repetitionsrate des Frequenzkamms detektiert und als RF-Signal zur Verfügung gestellt. Eine zweite Beat Detection Einheit wird hierbei genutzt, um das Signal einer anderen elektromagnetischen Strahlungs-Quelle und des Frequenzkamms zu überlagern und ein elektrisches Signal zu erzeugen, welches in einem Feedback Loop als Referenzsignalfür den Frequenzkamm dient.

In einer bevorzugten Ausführungsform weisen alle oder einige Uhren-Kanäle mit einer Strahlungs-Quelle im optischen Bereich, eine Beat Detection Einheit und einen Frequenz- und/oder Phasenunterschied zur elektromagnetischen Strahlungs-Quelle im Realisierungs-Kanal auf. Dieser Frequenz- und/oder Phasenunterschied für alle elektromagnetischen Wellen im optischen Spektrum ist mit Hilfe der jeweiligen Beat Detection Einheit des entsprechenden Uhren-Kanals und einem Frequenzkamm, welcher auf die elektromagnetische Strahlungs-Quelle des Realisierungs-Kanals stabilisiert ist, messbar.

In einer bevorzugten Ausführungsform ist der Frequenzkamm, der zur Messung der Frequenz- und/oder Phasenunterschiede zwischen den unterschiedlichen elektromagnetischen Wellen der Uhren-Kanäle und dem Realisierungs-Kanal genutzt wird, derselbe Frequenzkamm, wie er im Realisierungs-Kanal verwendet wird.

In einer bevorzugten Ausführungsform ist der Frequenzkamm zur Messung der Frequenz- und/oder Phasenunterschiede zwischen den unterschiedlichen Uhren-Kanälen und dem Realisierungs-Kanal, als separater Mess-Kanal mit separatem Frequenzkamm mit eigener, oder mit einem der Uhren-Kanäle geteilter Beat Detection Einheit ausgebildet, wobei der Frequenzkamm mit Hilfe der Beat Detection Einheit auf die Frequenz und Phase der elektromagnetischen Welle der elektromagnetischen Strahlungs-Quelle des Realisierungs-Kanals stabilisiert wird. Ein bevorzugter Mess-Kanal ist ein Kanal, in dem zwei oder mehr Uhrensignale verglichen werden.

In einer bevorzugten Ausführungsform wird die optische elektromagnetische Welle hinter dem Frequenzkamm des Realisierungs-Kanals mit Hilfe eines Frequenzwandlers in eine elektromagnetische Welle im Mikrowellenspektrum umgewandelt. Ein Frequenzwandler könnte bevorzugt als Frequenzkamm oder Frequenzkette (Siehe zum Beispiel H. Schnatz et al., PRL 76, 18 (1996)) ausgebildet sein. In einer bevorzugten Ausführungsform ist eine Anordnung "hinter" einem Bauteil als Anordnung "hinter" einem anderen Bauteil entlang eines optischen Wegs zu betrachten. Passiert eine elektromagnetische Welle erst Komponente A und dann Komponente B, so ist Komponente B "hinter" Komponente A angeordnet.

In einer weiteren bevorzugten Ausführungsform könnte die optische elektromagnetische Welle hinter dem Frequenzkamm des separaten Mess-Kanals mit Hilfe eines Frequenzwandlers in eine elektromagnetische Welle im Mikrowellenspektrum umgewandelt werden, welche optional insbesondere als zusätzlicher oder exklusiver Input für die Frequenz und Phasenversatz Berechnungseinheit zur Berechnung des Frequenz- und Phasenunterschieds genutzt wird. Dies hat den Vorteil, dass die Zähleinheit und die Frequenz- und Phasenversatz Berechnungseinheit wie in einem klassischen, reinen Mikrowellen Ensemble genutzt werden kann.

In einer weiteren bevorzugten Ausführungsform, in der der Frequenzkamm zur Messung der Frequenz- und/oder Phasenunterschiede zwischen den unterschiedlichen Uhren-Kanälen und dem Realisierungs-Kanal, als separater Mess-Kanal ausgebildet ist, könnte der Frequenz- und Phasen-Offset Generator zwischen der elektromagnetischen Strahlungs-Quelle im optischen Spektrum und der Beat Detection Einheit des Realisierungs-Kanals angeordnet sein. Ein so positionierter Frequenz- und Phasen-Offset Generator kann eine höhere Stabilität erreichen, da hier die Frequenz/Phase bereits im optischen Spektrum verschoben wird. In einer weiteren bevorzugten Ausführungsform weist die Beat Detection Einheit einen optischen Eingang für ein optisches Referenz-Signal auf (CW-Signal). In einer bevorzugten Ausführungsform wird das CW-Signal nach dem Frequenz- und Phasen-Offset Generator ausgekoppelt. Es ist weiterhin bevorzugt, dass das elektromagnetische Signal gepulst ausgekoppelt wird.

In einer weiteren bevorzugten Ausführungsform könnte der Frequenz- und Phasen-Offset Generator hinter dem Frequenzkamm und vor weiteren folgenden Komponenten des Realisierungs-Kanals angeordnet sein. In einer weiteren bevorzugten Ausführungsform weist die Beat Detection Einheit einen optischen Eingang für ein optisches Referenz-Signal auf (CW-Signal). In einer bevorzugten Ausführungsform wird das CW-Signal nach dem Frequenz- und Phasen-Offset Generator ausgekoppelt. Es ist weiterhin bevorzugt, dass das elektromagnetische Signal gepulst ausgekoppelt wird.

In einer weiteren bevorzugten Ausführungsform könnte der Frequenz- und Phasen-Offset Generator hinter dem Frequenzkamm und dem Frequenzwandler des Realisierungs-Kanals angeordnet sein. Dies hat den Vorteil, dass günstigere Komponenten, zum Frequenz- und/oder Phasenschieben im Mikrowellenspektrum verwendet werden können. Eine dieser bevorzugten Komponenten könnte ein Standard elektronischer Offset-Generator sein.

In einer optionalen Ausgestaltung der Erfindung weist der Frequenzkamm des Realisierungs-Kanals eine oder mehrere Zähleinheiten auf, welche die Frequenz- und Phasenunterschiede zwischen dem Realisierungs-Kanal und den unterschiedlichen Uhren-Kanälen vermessen kann. Bevorzugt weist der Frequenzkamm weiterhin eine BDU auf, wobei die Zähleinheit des Frequenzkamms das Signal der BDU zählt. Die Zähleinheit ist bevorzugt als Zeitintervallcounter ausgeführt. Bevorzugt wird das Uhrensignal des Realisierungskanals mit dem Signal des Frequenzkamms verglichen. Bevorzugt wandelt die BDU dieses Signal in ein elektrisches Signal um, sodass die Zähleinheit dieses zählen kann, oder die Frequenz des eingehenden Signals bestimmen kann. In einer bevorzugten Ausgestaltung werden hierfür die elektrischen Signale der jeweiligen Beat Detection Einheiten genutzt und an die Frequenz- und Phasenversatz Berechnungseinheit weitergeleitet. Auf diese Art lässt sich die Vorrichtung deutlich kompakter und mit weniger Komponenten bauen. Zusätzlich wird das Ensemble so robuster gegen Ausfall von einzelnen Uhren-Kanälen.

In einer weiteren bevorzugten Ausgestaltung werden alle oder einige der elektromagnetischen Wellen des Ensembles im Mikrowellenspektrum in optische Frequenzen umgewandelt und wie ein Uhren-Kanal im optischen Spektrum betrieben. Auf diese Weise können alle elektromagnetischen Strahlungs-Quellen auf die gleiche Art und Weise im optischen Spektrum beispielsweise mit Hilfe von Frequenzkämmen verglichen werden.

In einer alternativen bevorzugten Ausgestaltung werden alle, oder einige der elektromagnetischen Wellen der optischen Uhren-Kanäle in elektromagnetische Wellen im Mikrowellenspektrum umgewandelt und die Zähleinheit misst den Frequenz- und Phasenunterschied, gemeinsam mit den übrigen elektromagnetischen Strahlungs-Quellen im Mikrowellenspektrum.

Die Erfindung betrifft ferner ein Verfahren zur Erzeugung eines frequenzstabilen RF-Signals insbesondere unter Verwendung einer Vorrichtung zum Erzeugen eines frequenzstabilen RF-Signals, wie sie bisher beschrieben wurde. Das Verfahren umfasst die folgenden Schritte:

Zunächst wird der Frequenz- und/oder Phasenunterschied zwischen den einzelnen Uhren-Kanälen und dem Realisierungs-Kanal gemessen.

Anschließend wird aus den gemessenen Frequenzen und/oder Phasenunterschieden der Uhren-Kanäle eine gewichtete mittlere virtuelle Frequenzreferenz berechnet, welche einem idealen stabilisierten RF-Signal entspricht. Hierfür kann zum Beispiel der "Greenhall"-Algorithmus verwendet werden.

Anschließend wird die Frequenz und/oder Phase der Strahlungs-Quelle des Realisierungs-Kanals in Richtung der berechneten gewichteten mittleren virtuellen Frequenzreferenz verschoben. Das Ausgangssignal des Realisierungs-Kanals entspricht sodann dem Signal der berechneten virtuellen Frequenzreferenz. Bevorzugt wird dazu der Frequenz- oder Phasenunterschied des Realisierungskanals zu einem Uhren-Kanal benötigt.

Ein optionaler Frequenzwandler wird genutzt um Frequenzen mit einer hohen Frequenz auf eine niedrigeres Frequenzspektrum, oder umgekehrt herunter oder hoch zu transformieren. Die Qualität, wie Frequenz- und Phasenstabilität des niederfrequenten Signals behält dabei die Qualität der Ursprungsfrequenz. Ein Frequenzwandler ist bevorzugt als optischer Frequenzkamm ausgebildet.

Im Folgenden werden bevorzugte Ausführungsformen der Erfindung anhand von Figuren erläutert.

Es zeigen:
- Fig. 1:: Reines Optisches Ensemble mit getrennten Mess- und Realisierungskanal
- Fig. 2:: Reines Optisches Ensemble mit Mess- und Realisierungskanal durch einen optischen Frequenzkamm
- Fig. 3:: Gemischtes Ensemble mit Realisierung des frequenzstabilen RF-Signals im Mikrowellenspektrum
- Fig. 4:: Realisierung eines Uhrenensembles mittels optischem Stellglied

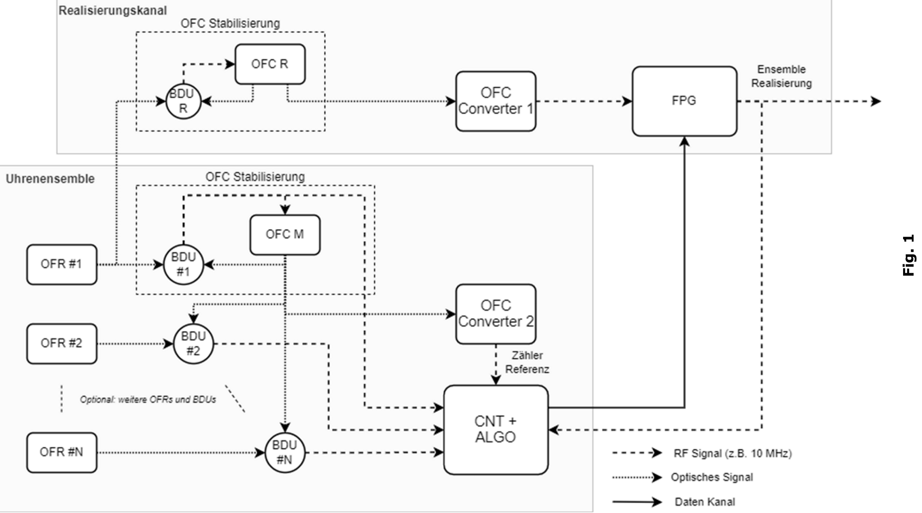

Die Vorrichtung zum Erzeugen eines frequenzstabilen RF-Signals gemäß Fig. 1 weist einen Realisierungskanal sowie Uhren-Kanäle und einen dedizierten Mess-Kanal auf.

Der Realisierungskanal (mit Suffix R gekennzeichnet) gemäß Fig. 1 weist folgende Komponenten auf:
a. Eine optische Frequenz Referenz OFR #1 mit einer Beat Detection Einheit BDU R
b. Einen optischen Frequenzkamm OFC R
c. Einen Frequenzwandler OFC Converter 1, welcher die Repetitionsrate des optisch gepulsten Signals des optischen Frequenzkamms OFC R in ein bevorzugt Sinusförmiges RF-Signal im Mikrowellenbereich umwandelt
d. Einen Frequenz- und Phasen-Offset Generator FPG
e. Ein Ausgang für das frequenzstabile RF-Signal (Ensemble Realisierung)

In Fig. 1 wird das Signal der optischen Frequenzreferenz OFR #1 mit dem Signal des optischen Frequenzkamms OFC R überlagert und die daraus resultierende Schwebung mit der Beat Detection Einheit BDU R gemessen. Das von der Beat Detection Einheit BDU R gemessene Signal wird von dem optischen Frequenzkamm OFC R als Referenz genutzt, sodass OFC R auf die optische Frequenzreferenz OFR #1 gelockt wird. Ein Signal (bevorzugt die Repetitionsrate bzw. bevorzugt der optische Pulszug) des auf die optische Frequenzreferenz OFR #1 gelockten optischen Frequenzkamms OFC R wird an einen Frequenzwandler OFC Converter 1 geleitet, um dessen Signal vom optischen Spektrum ins Mikrowellenspektrum zu übertragen. Das so erzeugte Mikrowellensignal wird vom Frequenz- und Phasen-Offset Generator FPG in Frequenz und/oder Phase verschoben, sodass hinter dem Frequenz- und Phasen-Offset Generator FPG das frequenzstabile RF-Signal abgegriffen werden kann.

Die Uhren-Kanäle gemäß Fig. 1 weisen folgende Komponenten auf:
a. Je eine optische Frequenzreferenz OFR #1 - OFR #N
b. Je eine Beat Detection Einheit BDU #1 - BDU #N

Der dedizierte Mess-Kanal gemäß Fig. 1 weist folgende Komponenten auf:
a. Einen optischen Frequenzkamm OFC M
b. Eine Beat Detection Einheit BDU #1
c. Einen Frequenzwandler OFC Converter 2, welcher das optische Signal des optischen Frequenzkamms OFC M in ein RF-Signal im Mikrowellenbereich umwandelt
d. Eine Zähleinheit mit Frequenz- und Phasenversatz-Berechnungseinheit CNT + ALGO

In Fig. 1 wird das Signal der optischen Frequenzreferenz OFR #1 mit dem Signal des optischen Frequenzkamms OFC M überlagert und die daraus resultierende Schwebung mit der Beat Detection Einheit BDU #1 gemessen. Das von der Beat Detection Einheit BDU #1 gemessene Signal wird von dem optischen Frequenzkamm OFC M als Referenz genutzt, sodass OFC M auf die optische Frequenz Referenz OFR #1 gelockt wird. Ein Signal des auf die optische Frequenz Referenz OFR #1 gelockten optischen Frequenzkamms OFC M wird an einen Frequenzwandler OFC Converter 2 geleitet, um dessen Signal vom optischen Spektrum ins Mikrowellenspektrum zu übertragen. Das so erzeugte Mikrowellensignal wird von der Zähleinheit mit Frequenz- und Phasenversatz Berechnungseinheit CNT + ALGO genutzt, um Frequenzunterschiede zwischen den einzelnen Uhren-Kanälen und dem Realisierungskanal zu zählen und zu berechnen.

Des Weiteren werden in Fig. 1 die Uhren-Kanal-Signale an BDU #2 -BDU #N mit einem Signal des auf die optische Frequenzreferenz OFR #1 gelockten optischen Frequenzkamms OFC M überlagert. Die daraus resultierenden Schwebungen werden mit den Beat Detection Einheit BDU #2 - BDU #N gemessen und von der Zähleinheit mit Frequenz- und Phasenversatz Berechnungseinheit CNT + ALGO gezählt und verarbeitet. Die Zähleinheit mit Frequenz- und Phasenversatz Berechnungseinheit CNT + ALGO vermisst den Frequenzunterschied zwischen dem Mikrowellensignal des OFC Converter 2 und dem jeweiligen Signal der BDU #2 - BDU #N. Aus den vermessenen und verarbeiteten Signalen berechnet die Frequenz- und Phasenversatz Berechnungseinheit eine gewichtete mittlere virtuelle Frequenzreferenz. Basierend auf der gewichteten mittleren virtuellen Frequenzreferenz verschiebt der Frequenz- und Phasen-Offset Generator FPG das Signal des OFC Converter 1 des Realisierungskanals in Richtung der berechneten gewichteten mittleren virtuellen Frequenzreferenz, sodass ein frequenzstabiles RF-Signal am Ende des Realisierungs-Kanals abgreifbar ist.

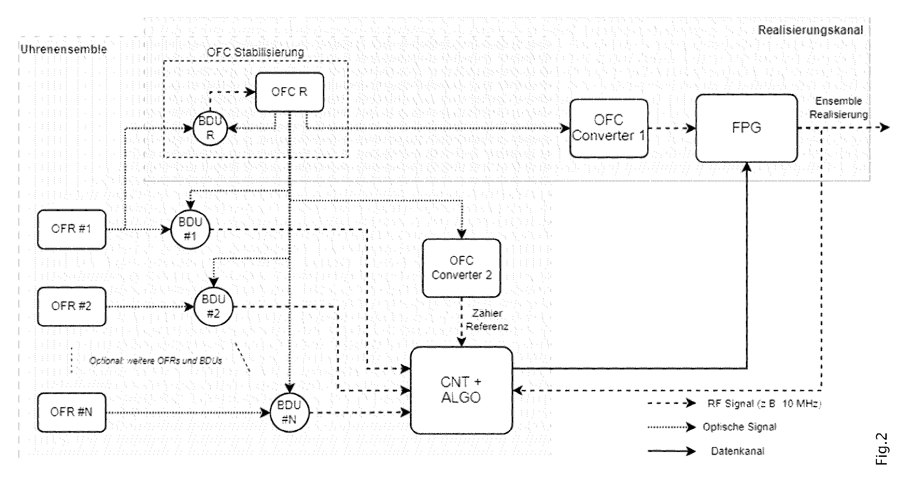

Die Vorrichtung zum Erzeugen eines frequenzstabilen RF-Signals gemäß Fig. 2 weist einen Realisierungskanal, sowie Uhren-Kanäle und einen integrierten Mess-Kanal auf.

Der Realisierungskanal gemäß Fig. 2 weist folgende Komponenten auf:
a. Eine optische Frequenzreferenz OFR #1 mit einer Beat Detection Einheit BDU R
b. Einen optischen Frequenzkamm OFC R
c. Einen Frequenzwandler OFC Converter 1, welcher das optische Signal des optischen Frequenzkamms OFC R in ein RF-Signal im Mikrowellenbereich umwandelt
d. Einen Frequenz- und Phasen-Offset Generator FPG
e. Ein Ausgang für das frequenzstabile RF-Signal (Ensemble Realisierung)

In Fig. 2 wird das Signal der optischen Frequenzreferenz OFR #1 mit dem Signal des optischen Frequenzkamms OFC R überlagert und die daraus resultierende Schwebung mit der Beat Detection Einheit BDU R gemessen. Das von der Beat Detection Einheit BDU R gemessene Signal wird von dem optischen Frequenzkamm OFC R als Referenz genutzt, sodass OFC R auf die optische Frequenzreferenz OFR #1 gelockt wird. Ein Signal des auf die optische Frequenzrreferenz OFR #1 gelockten optischen Frequenzkamms OFC R wird an einen Frequenzwandler OFC Converter 1 geleitet, um dessen Signal vom optischen Spektrum ins Mikrowellenspektrum zu übertragen. Das so erzeugte Mikrowellensignal wird vom Frequenz- und Phasen-Offset Generator FPG in Frequenz und/oder Phase verschoben, sodass hinter dem Frequenz- und Phasen-Offset Generator FPG das frequenzstabile RF-Signal abgegriffen werden kann.

Die Uhren-Kanäle gemäß Fig. 2 weisen folgende Komponenten auf:
a. Je eine optische Frequenzreferenz OFR #1 - OFR #N
b. Je eine Beat Detection Einheit BDU #1 - BDU #N

Die integrierten Mess-Kanäle gemäß Fig. 2 weisen folgende Komponenten auf:
a. Je eine Beat Detection Einheit BDU #1 - BDU #N
b. Eine Zähleinheit mit Frequenz- und Phasenversatz Berechnungseinheit CNT + ALGO

In Fig. 2 übernimmt die Funktion des OFC M aus Fig. 1 ebenfalls der OFC R. Des Weiteren wird in Fig. 2 das Signal der optischen Frequenzreferenz OFR #1 mit dem Signal des optischen Frequenzkamms OFC R überlagert und die daraus resultierende Schwebung mit der Beat Detection Einheit BDU #1 gemessen und von der Zähleinheit mit Frequenz- und Phasenversatz-Berechnungseinheit CNT + ALGO gezählt und verarbeitet. Zusätzlich werden die Uhren-Kanal-Signale an BDU #2 -BDU N mit einem Signal des auf die optische Frequenzreferenz OFR #1 gelockten optischen Frequenzkamms OFC R überlagert. Die daraus resultierenden Schwebungen werden mit den Beat Detection Einheit BDU #2 - BDU #N gemessen und von der Zähleinheit mit Frequenz- und Phasenversatz-Berechnungseinheit CNT + ALGO gezählt und verarbeitet. Die Zähleinheit mit Frequenz- und Phasenversatz Berechnungseinheit CNT + ALGO zählt den Frequenzunterschied zwischen den gemessenen BDU #1 Signalen und den BDU #2 - BDU #N Signalen. Aus den gezählten und verarbeiteten Signalen berechnet die Frequenz- und Phasenversatz-Berechnungseinheit eine gewichtete mittlere virtuelle Frequenzreferenz. Basierend auf der gewichteten mittleren virtuellen Frequenzreferenz verschiebt der Frequenz- und Phasen-Offset Generator FPG das Signal des OFC Converter 1 des Realisierungskanals in Richtung der berechneten gewichteten mittleren virtuellen Frequenzreferenz, sodass ein frequenzstabiles RF-Signal am Ende des Realisierungs-Kanals abgreifbar ist.

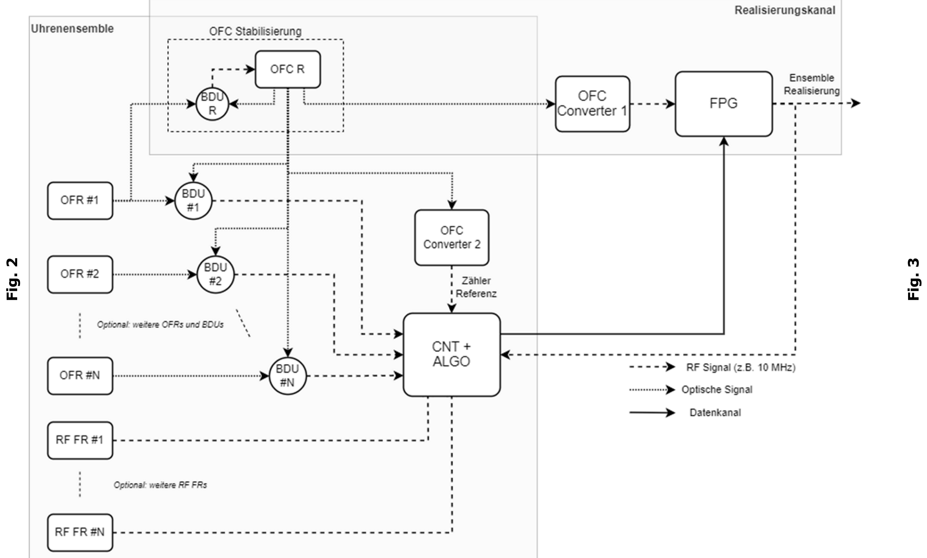

Die Vorrichtung zum Erzeugen eines frequenzstabilen RF-Signals gemäß Fig. 3 weist einen Realisierungskanal, sowie Uhren-Kanäle und einen integrierten Mess-Kanal, äquivalent zu Fig. 2 auf. Des Weiteren weist die Vorrichtung gemäß Fig. 3 Frequenzreferenzen im Mikrowellenspektrum FR #1 - FR #N auf.

Die Frequenzreferenzen im Mikrowellenspektrum FR #1 - FR #N in Fig. 3 werden als zusätzliche Frequenzreferenzen für die Zähleinheit mit Frequenz- und Phasenversatz-Berechnungseinheit CNT + ALGO genutzt, um die gewichtete mittlere virtuelle Frequenzreferenz zu berechnen. Zusammengefasst zeigt Fig. 3 ein gemischtes Ensemble aus Frequenzreferenzen im optischen Spektrum und Mikrowellenspektrum. So könnte die Vorrichtung nach Fig. 1 oder Fig. 2 zum Beispiel gemeinsam mit existierenden Ensembles im Mikrowellenspektrum betrieben werden.

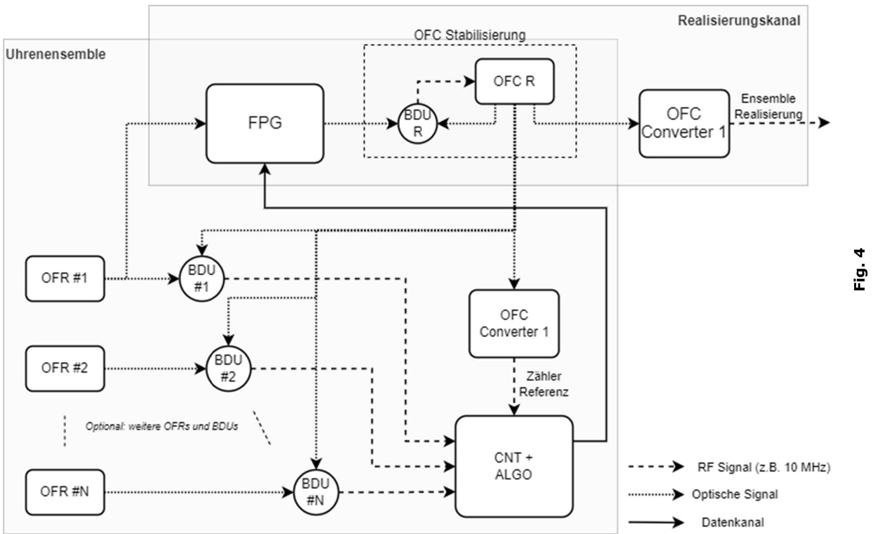

Die Vorrichtung zum Erzeugen eines frequenzstabilen RF-Signals gemäß Fig. 4 weist einen Realisierungskanal, sowie Uhren-Kanäle und einen integrierten Mess-Kanal, äquivalent zu Fig. 2 auf. Des Weiteren weist die Vorrichtung gemäß Fig. 4 keinen Frequenz- und Phasen-Offset Generator FPG hinter dem optischer Frequenzkamm OFC Converter 1 auf. Stattdessen sitzt der Frequenz- und Phasen-Offset Generator FPG in der optischen Strecke vor dem Frequenzwandler OFC Converter 1, bevorzugt zwischen OFR #1 und BDU R. Diese Anordnung hat den Vorteil, dass die Frequenz bereits im optischen Spektrum verschoben wird, was eine genauere Verschiebung der Frequenz und/oder Phase erlaubt.

## Patentansprüche

1. Vorrichtung zum Erzeugen eines frequenzstabilen RF-Signals, wobei die Vorrichtung aufweist:
a. mehrere elektromagnetische Strahlungs-Quellen (OFR #1 - OFR #N; FR #1 - FR #N), insbesondere im optischen Spektrum, wie Laser und/oder Maser im Mikrowellen Spektrum, welche eine kohärente elektromagnetische Welle einer bestimmten Frequenz emittieren,
b. einen Realisierungs-Kanal, welcher eine der mehreren elektromagnetischen Strahlungs-Quelle aufweist (OFR #1; FR #1) und deren elektromagnetische Welle auf einen gewichteten mittleren Frequenz- und Phasen-Wert stabilisiert und so ein gewichtetes mittleres frequenzstabiles RF-Signal erzeugt,
c. mindestens einen Uhren-Kanal, welcher eine weitere der mehreren elektromagnetischen Strahlungs-Quellen (OFR #1 - OFR #N, FR #1 - FR #N) aufweist, die nicht Teil des Realisierungs-Kanals aus b) ist,
d. mindestens eine Zähleinheit, welche die Frequenz- und Phasenunterschiede zwischen dem Realisierungs-Kanal und den unterschiedlichen Uhren-Kanälen vermisst,
e. mindestens eine Frequenz- und Phasenversatz Berechnungseinheit, welche basierend auf allen oder einer Untermenge der Frequenz- und/oder Phasenunterschiede des Realisierungs-Kanals und der unterschiedlichen Uhren-Kanäle eine gewichtete mittlere virtuelle Frequenzreferenz berechnet,
f. mindestens einen Frequenz- und Phasen-Offset Generator, welcher, basierend auf der gewichteten mittleren virtuellen Frequenzreferenz der Frequenz und Phasenversatz Berechnungseinheit, die Frequenz und/oder Phase des Realisierungs-Kanals in Richtung der berechneten gewichteten mittleren virtuellen Frequenzreferenz verschiebt.

2. Vorrichtung nach einem der vorherigen Ansprüche, **dadurch gekennzeichnet, dass** der Realisierungs-Kanal folgende Komponenten aufweist:
a. die elektromagnetische Strahlungs-Quelle im optischen Spektrum,
b. eine Beat Detection-Einheit,
c. einen Frequenzkamm,
wobei der Frequenzkamm mit Hilfe der Beat Detection-Einheit auf die Frequenz und Phase der elektromagnetischen Welle der elektromagnetischen Strahlungs-Quelle im optischen Spektrum des Realisierungskanals stabilisiert wird.

3. Vorrichtung nach Anspruch 2, **dadurch gekennzeichnet, dass** alle Uhren-Kanäle, eine Beat Detection Einheit und einen Frequenz- und/oder Phasenunterschied zur elektromagnetischen Strahlungs-Quelle im Realisierungs-Kanal aufweisen und dieser Frequenz- und/oder Phasenunterschied für alle elektromagnetischen Wellen im optischen Spektrum mit Hilfe der jeweiligen Beat Detection Einheit des entsprechenden Uhren-Kanals und einem Frequenzkamm, welcher auf die elektromagnetische Strahlungs-Quelle des Realisierungs-Kanals stabilisiert ist, gemessen wird.

4. Vorrichtung nach Anspruch 3, **dadurch gekennzeichnet, dass** der Frequenzkamm zur Messung der Frequenz- und/oder Phasenunterschiede zwischen den unterschiedlichen elektromagnetischen Wellen der Uhren-Kanäle und dem Realisierungs-Kanal, derselbe Frequenzkamm ist, wie er im Realisierungs-Kanal verwendet wird.

5. Vorrichtung nach Anspruch 3, **dadurch gekennzeichnet, dass** der Frequenzkamm zur Messung der Frequenz- und/oder Phasenunterschiede zwischen den unterschiedlichen Uhren-Kanälen und dem Realisierungs-Kanal, als separater Mess-Kanal mit separatem Frequenzkamm mit eigener Beat Detection Einheit ausgebildet ist, wobei der Frequenzkamm mit Hilfe der Beat Detection Einheit auf die Frequenz und Phase der elektromagnetischen Welle der elektromagnetischen Strahlungs-Quelle des Realisierungs-Kanals stabilisiert wird.

6. Vorrichtung nach einem der Ansprüche 2-5, **dadurch gekennzeichnet, dass** die optische elektromagnetische Welle hinter dem Frequenzkamm des Realisierungs-Kanals mit Hilfe eines Frequenzwandlers in eine elektromagnetische Welle im Mikrowellen Spektrum umgewandelt wird.

7. Vorrichtung nach Anspruch 5 oder 6, **dadurch gekennzeichnet, dass** die optische elektromagnetische Welle hinter dem Frequenzkamm des separaten Mess-Kanals mit Hilfe eines Frequenzwandlers in eine elektromagnetische Welle im Mikrowellen Spektrum umgewandelt wird, welches optional insbesondere als zusätzlicher oder exklusiver Input für die Frequenz und Phasenversatz Berechnungseinheit zur Berechnung des Frequenz- und Phasenunterschieds genutzt wird.

8. Vorrichtung nach Anspruch 5, **dadurch gekennzeichnet, dass** der Frequenz- und Phasen-Offset Generator zwischen einer der elektromagnetischen Strahlungs-Quelle im optischen Spektrum und der Beat Detection Einheit des Realisierungs-Kanals angeordnet ist.

9. Vorrichtung nach Anspruch 2, **dadurch gekennzeichnet, dass** der hochauflösende Frequenz- und Phasen-Offset Generator hinter dem Frequenzkamm und vor weiteren folgenden Komponenten des Realisierungs-Kanals angeordnet ist.

10. Vorrichtung nach Anspruch 6, **dadurch gekennzeichnet, dass** der hochauflösende Frequenz- und Phasen-Offset Generator hinter dem Frequenzkamm und dem Frequenzwandler des Realisierungs-Kanals angeordnet ist.

11. Vorrichtung nach einem der vorherigen Ansprüche, **dadurch gekennzeichnet, dass** der Frequenzkamm des Realisierungs-Kanals eine oder mehrere Zähleinheiten aufweist, welche die Frequenz- und Phasenunterschiede zwischen dem Realisierungs-Kanal und den unterschiedlichen Uhren-Kanälen vermisst.

12. Vorrichtung nach einem der vorherigen Ansprüche, **dadurch gekennzeichnet, dass** die elektromagnetischen Wellen eines Ensembles im Mikrowellen Spektrum in optische Frequenzen umgewandelt werden und wie ein Uhren-Kanal im optischen Spektrum betrieben werden.

13. Vorrichtung nach einem der vorherigen Ansprüche, **dadurch gekennzeichnet, dass** die elektromagnetischen Wellen eines oder mehrerer optischen Uhren-Kanäle in Mikrowellen umgewandelt werden und die Zähleinheit den Frequenz- und Phasenunterschied, gemeinsam mit den elektromagnetische Welle im Mikrowellen Spektrum misst.

14. Verfahren zum Erzeugen eines frequenzstabilen RF-Signals, insbesondere unter Verwendung einer Vorrichtung nach einem der Ansprüche 1 - 13, mit folgenden Verfahrensschritten:
a. messen der Frequenz- und Phasenunterschiede zwischen den einzelnen Uhren-Kanälen und dem Realisierungs-Kanal,
b. berechnen einer virtuellen Frequenzreferenz,
c. verschieben der Frequenz und/oder Phase der Strahlungs-Quelle des Realisierungs-Kanals in Richtung der berechneten gewichteten mittleren virtuellen Frequenzreferenz.
